# EUROPEAN PATENT APPLICATION

(11) **EP 2 466 639 A2**
(43) Date of publication of application: **20.06.2012**
(21) Application number: 11169984.9
(22) Date of filing: 15.06.2011
(51) Int. Cl.: H01L 25/075, H01L 33/50

(54) **A high-color rendering LED and manufacturing method thereof**

(30) Priority: 18.12.2010 CN 201010594150
(71) Applicant: MLS Co., Ltd., Xiaolan Town, ZhongShan Guangdong 528-400 (CN)
(72) Inventor: Liu, Tianming, Xiaolan Town, ZhongShan Guangdong 528400 (CN)
(74) Representative: Hooiveld, Arjen Jan Winfried

(57) **Abstract**

A high color rendering LED, comprising a holder and two holder pins, wherein the holder is provided with a cup room, a blue LED chip and a red LED chip are mount in the cup room and connected in series, the serially connected blue LED chip and red LED chip are further connected to the holder pins, and in the cup room the blue LED chip and red LED chip are covered by the fluorescent gel. The present invention adds the dark red in its spectrum, whereby its R9 test index is effectively improved.

## Description

### Technical Field

The invention relates to a light-emitting diode (LED), and more particularly to a high-color rendering LED and the manufacturing method thereof.

### The Prior Art/Background

Along with the economic and social development, the scientific and technological progress, as well as the continuous industrialization of LED, LED lighting is becoming more common. At present, there are a growing number of the LED lighting lamps in the market for different purposes, but in some professional occasions, such as lighting in halls, art galleries, offices and other like places, where better color reduction is required, the stringent requirements may not be satisfied.

The color rendering index (CRI) (sometimes called color rendition index), is a quantitative measure of the ability of a light source to reproduce the colors of various objects and consists of 14 indicators (shows in the following table). By comparing the similarity of every color with an ideal or natural light source and then calculating, the CRI is obtained.

**Table 1 color rendering index table**

| Ri | Color in daylight | Ri | Color in daylight |
|---|---|---|---|
| R1 | Light grayish red | R8 | Light reddish purple |
| R2 | Dark grayish yellow | R9 | Dark red |
| R3 | Dark yellow green | R10 | Dark yellow |
| R4 | Moderate yellowish green | R11 | Dark green |
| R5 | Light bluish green | R12 | Dark blue |
| R6 | Light blue | R13 | Light yellowish pink |
| R7 | Light violet | R14 | Leaf green |

A CRI of greater than 85 is considered suitable for lighting in all sites. However, as in general a conventional white LED is made of a blue LED and the yellow phosphor, the white light from such a LED contains the blue and yellow spectrums only, which are discontinuous and of which the spectrum width is relatively narrow, it cannot reproduce all real colors, especially because the white light lacks of the dark red spectrum, its color rendering index could not be effectively improved. In addition, for achieving a high color rendering white LED, another manufacturing method could be: adding the red fluorescent powder to the fluorescent gel for spectrum compensation, but because of the low excitation efficiency of the red fluorescent powder added, the overall luminous efficiency of the LED will be reduced, and thus cannot meet the requirements of lighting in some professional fields.

### Summary

The objective of the invention is to provide a LED with better color reproduction and higher color rendering, and the manufacturing method thereof.

The technical solution adopted by the present invention to solve the technical problems described above is elaborated as below:
A high color rendering LED, comprising a holder and holder pins, said holder being provided with a cup room in which a blue LED chip and a red LED chip connected in series are mounted, said serially connected blue LED chip and red LED chip being connected to said holder pins, said cup room further containing yellow fluorescent gel covering said blue LED and red LED.

Said blue LED chip emits to excite the fluorescent powder in said yellow fluorescent gel to emit yellow light, the luminous flux ratio of the white light which is produced by the yellow light and blue light mixed, and the red light which is produced by the red LED, is from 1:4 to 1:8.

A high-color rendering LED manufacturing method, comprising the following steps:
Step 1, placing the blue and red LED chips into the cup room of the holder.
Step 2, connecting one pole of the blue LED chip to one pole of the red LED chip to form a serial connection, and then connecting the blue and red LED chips serially connected to the pins of the holder.
Step 3, coating the cup room with the yellow fluoresce power gel.

The advantages of the present invention could be:
In the present invention the blue and red LED chips adopted are connected in series and cooperated with the yellow fluoresce gel to emit white light. When excited by the blue light, the fluorescent powder absorbs energy to jump into an excitation state (a unstable state), and releases energy in a form of light while jumping back into the ground state. It is known that the shorter the wavelength, the higher the energy is, the excited light emitting of the fluorescent powder is an exchange process of light energy to light rays, where only the high-energy light rays could be transferred to the low-energy light rays, as in wavelength the blue light is shorter than the yellow light, and the yellow light is further shorter than the red light, the blue light from the blue LED is able to simulate the fluorescent powder to emit yellow light, which is further mixed with the blue light to produce the white light, meanwhile the red light from the red LED chip is not able to excite the fluorescent powder to emit any visible light rays, thus the eventual light produced is a mixture of the white light and the red light, in other words, the dark red light is added into the spectrum of the product disclosed by the present invention, which consequently improve the R9 test index. In addition, the brightness of the LED disclosed by the present invention is not impaired as no red fluorescent powder is added. Furthermore, as the blue LED chip and the red LED chip are placed in a same cup room and covered by the fluorescent powder, there is no difference between the product disclosed by the present invention and the ordinary LEDs in appearance. The product provided by the present invention lights uniformly, the problems such as color stratifying and light speckle are eliminated. At last, the LED chips used in the present invention are connected in series, no peripheral circuits are required, the product could be directly connected to the power source and operate, its structure is simple but highly efficient.

### Description of the Drawings

The detailed description of the present invention are as follows accompanying with drawings and the preferred embodiments:
Fig. 1 is a circuit schematic diagram of the present invention;
Fig. 2 is a side view of the first embodiment of the present invention;
Fig. 3 is a top view of the first embodiment of the present invention;
Fig. 4 is a side view of the second embodiment of the present invention;
FIG. 5 is a spectral graph of the LED according to the present invention.

### The Preferred Embodiments

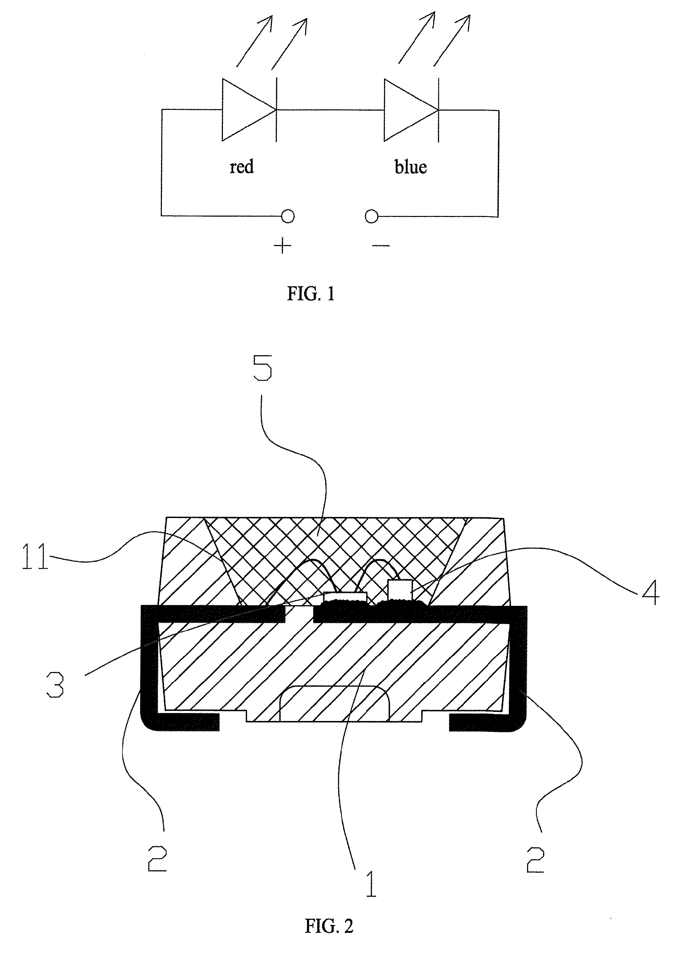

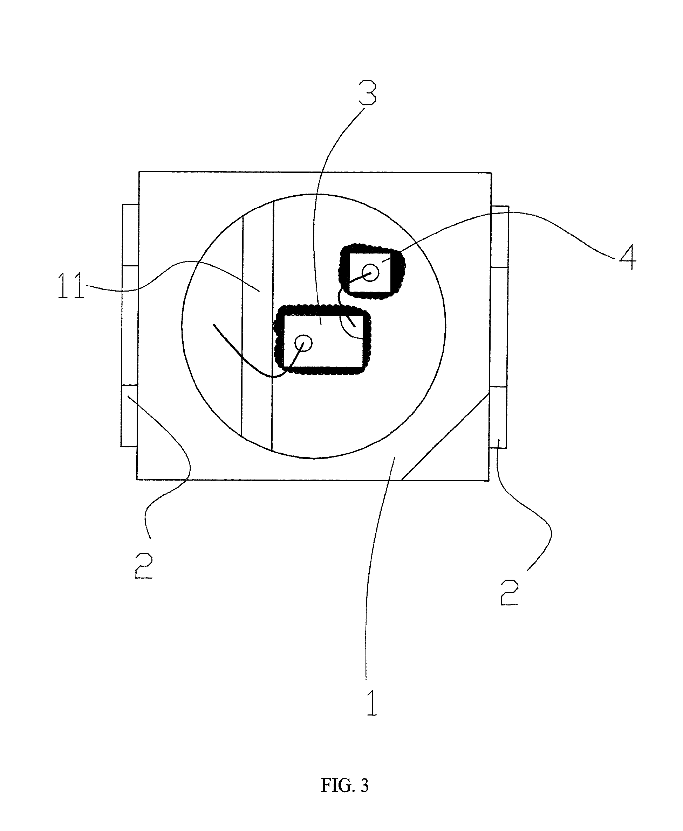

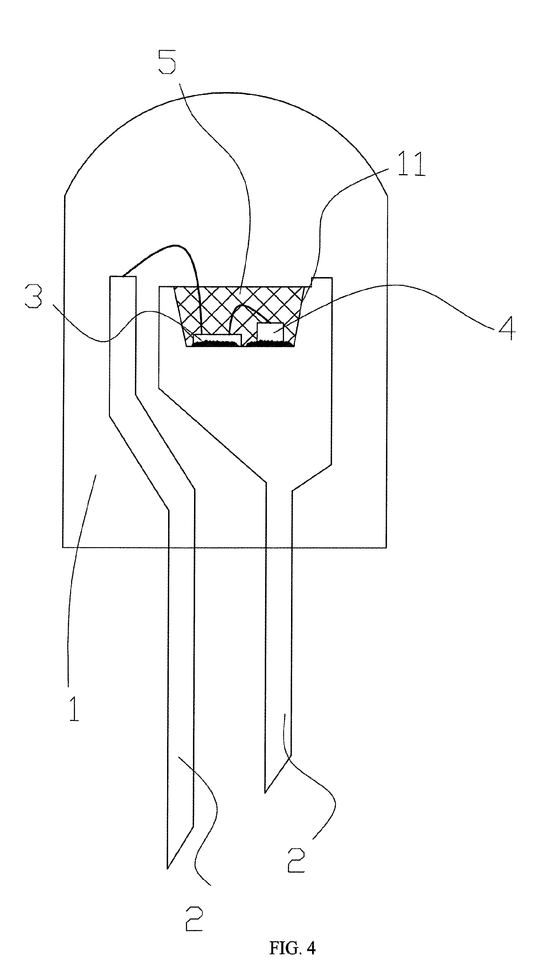

As shown in FIG. 1 to FIG. 4, the high color rendering LED disclosed by the present invention comprises a holder 1 and two holder pins 2, as shown in FIG. 2 and 3, the holder 1 could be a surface-mount type, or an in-line type, as shown in FIG. 4, depending on different occasions of use. In detail, the holder 1 is provided with a cup room 11, in which a blue LED chip 3 and a red LED chip 4 are fixed, wherein the blue and red LED chips 3, 4 are connected in series, in general a metal wire is used herein for bonding and connecting the two LED chips 3, 4, separately as two welding spots. The blue LED chip 3 and the red LED chip 4 are welded together by a metal wire, and the two poles of the serially connected blue and red LED chips 3, 4 are connected to the two holder pins 2 which extend to the outside of the holder 1 for the electric connection. In general the blue LED chip 3 operates at a nominal voltage of 3.0 to 3.5V, the red LED chip 4 operates at a nominal voltage of 1.8 to 2.2V, and a 20mA positive current could be sufficient to ensure the proper functioning of the two LED chips, no extra peripheral control circuit is required, its use thus becomes more convenient.

To arrange the LED chips in the present invention, the blue LED chip 3 is fixed in the cup room 11 in a way where its two poles are horizontally arranged, while the red LED chip 4 is fixed in a way where its two poles are vertically arranged. For a surface-mount type holder 1, one holder pin 2 directly extends into the cup room 11 from the bottom of the cup room 11, one pole of the red LED chip 4 is directly fixed on the holder pin 2, forming an electrical connection, and the other pole (the upper one) is connected with one pole of the blue LED chip by a metal wire, the other pole of the blue LED chip 3 is connected to the other holder pin 2 by another metal wire, thus the two poles of the two LED chips 3, 4 connected in series are led out. For an in-line type holder 1, its cup room 11 is set in one of the holder pins 2, thus one of the poles of the red LED chip 4 is directly connected into the cup room 11, and other connections are similar; as to ensure a same polarity direction, in general two approaches are adopted. In the first approach, the red LED chip 4 has a positive pole on the bottom thereof and a negative pole on the top thereof, wherein the negative pole of the red LED chip 4 is connected with the positive pole of the blue LED chip 3, and the negative pole of the blue LED chip 3 is connected with the other holder pin 2; in the second approach, the polarity of the two holder pins 2 are opposite to them in the first approach, special attention is needed herein to separate the polarity of the LED chips.

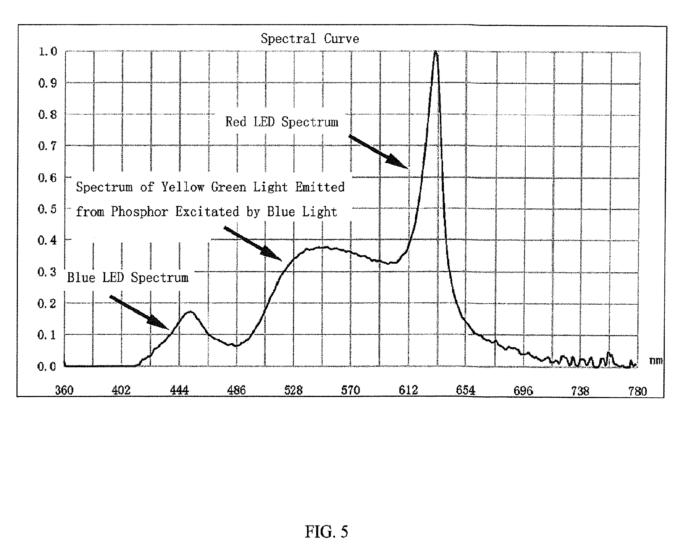

Once the blue and red LED chips 3, 4 are secured in the cup room 11, the yellow fluorescent gel 5 is coated inside the cup room 11 for packaging them together. The luminescence mechanism of the present invention could be described as: the blue LED 3 emits to excite the yellow fluorescent gel to emit yellow light, the yellow light gained and the blue light from the blue LED chip 3 are further mixed to produce white light, while the red light emitted by the red LED chip 4 cannot be absorbed by the yellow fluorescent gel, thus the light eventually produced is a mixture of the red light and white light, whereby better color rendering performance is achieved. According to the requirements on color temperature, the brightness of the red Led chip 4 and the white light is adjustable in a certain range. In general, lower color temperature means larger percentage of the red light in the mixed light, as shown by the spectral curve in FIG. 5, it is observed that a high color rendering white light could be achieved by mixing the three primary colors (Red, Green and Blue) together, wherein the luminous flux ratio of R, G and B could be 1:4.5907 : 0.0601, and their wavelengths are 700nm, 546.1nm and 435.8nm respectively. However in the actual production, the yield of the blue LED chips with a wavelength of 435.8nm is relatively low, the blue LED chips used in mainstream production usually have the wavelengths of from 440 to 465nm instead, and the yellow green light produced by the fluorescent gel excited by blue light is used as the green light. The wave peaks is between 520 to 580nm in common. As shorter emitting wave peaks means lower emitting efficiency for the fluorescent gel, in actual production the fluorescent gel with an emitting wave peak of greater than 560nm is adopted. Furthermore, as limited by the chip material, the brightness of the 700nm red LED chips could not be further improved, thus the red LED chips with the wavelengths of 610 to 640nm in particular from 618 to 625nm are mainly used. The light flus ratio may also slightly vary. Resulting from above, as a preferred embodiment, the luminous flux ratio of the white light mixed by the blue light from the blue LED chip 3 and the yellow light from the fluorescent gel 5, and the red light from the red LED chip 4, is from 1:4 to 1:8.

For the high color rendering LED disclosed by the invention, its manufacture can be achieved through the following steps:
Step 1, mounting the blue LED chip 3 and the red LED chip 4 in the cup room 11 of the holder 1;
Step 2, connecting one pole of the blue LED chip 3 with one pole of the red LED chip 3 to form a serial connection, and then connecting the blue and red Led chips 3, 4 which are connected in series to the holder pins 2 of the holder 1;
Step 3, coating the cup room 11 with the yellow fluoresce power gel 5.

It is apparent that the present invention adds a dark red spectrum into the white spectrum, so as to improve the R9 test index, and as no red fluorescent gel is involved, the brightness of the product will not be impacted. In addition, as the blue LED chip and red Led chip are placed in a same cup room and covered by the fluorescent gel, there is no difference with the common LEDs in appearance, and more importantly, the product according to the present invention lights uniformly, and has no color layering.

While the invention has been described in terms of what are presently considered to be the most practical and preferred embodiments, it is to be understood that the invention need not be limited to the disclosed embodiment. On the contrary, it is intended to cover various modifications and similar arrangements included within the spirit and scope of the appended claims which are to be accorded with the broadest interpretation so as to encompass all such modifications and similar structure.

## Claims

1. A high color rendering LED, comprising a holder (1) and holder pins (2), said holder (1) being provided with a cup room (11) in which a blue LED chip (3) and a red LED chip (4) are mounted and connected in series, said serially connected blue LED chip (3) and red LED chip (4) being connected to said holder pins (2), said cup room (11) containing yellow fluorescent gel (5) covering said blue LED (3) chip and red LED chip (4).

2. The high color rendering LED according to claim 1,
wherein said blue LED chip (3) emits to excite the fluorescent powder in said yellow fluorescent gel (5) to emit yellow light, the luminous flux ratio of the white light which produced by the yellow light and blue light mixed, and the red light which is produced by the red LED chip (4), is from 1:4 to 1:8.

3. The high color rendering LED according to claim 1,
wherein the blue LED chip (3) and the red LED chip (4) are bonded and connected by a metal wire.

4. The high color rendering LED according to claim 3,
wherein one pole of the blue LED chip (3) is connected to the upper pole of the red LED chip (4) by a metal wire, the other pole of the blue LED chip is connected to one of the holder pins (2) by another metal wire, the lower pole of the red LED chip (4) is fixedly connected to the other holder pin (2).

5. The high color rendering LED according to claim 1,
wherein the holder (1) is a surface mount type or in-line type.

6. A manufacturing method for the high color rendering LED, comprising the following steps:
Step 1, mounting the blue LED chip (3) and the red LED chip (4) into the cup room (11) of the holder (1);
Step 2, connecting one pole of the blue LED chip (3) to one pole of the red LED chip (4) to form a serial connection, and then connecting the serially connected blue LED chip (3) and red LED chip (4) to the holder pins (2);
Step 3, coating the yellow fluorescence gel (5) in the cup room (11).
